Europäisches Patentamt

European Patent Office

Office européen des brevets

(19)

(11) EP 0 897 221 A1

(12) **EUROPÄISCHE PATENTANMELDUNG**

(43) Veröffentlichungstag:
17.02.1999 Patentblatt 1999/07

(51) Int Cl.$^6$: **H03L 7/23**

(21) Anmeldenummer: 98401803.6

(22) Anmeldetag: 17.07.1998

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **11.08.1997 DE 19734656**

(71) Anmelder: **ALCATEL**
**75008 Paris (FR)**

(72) Erfinder:
• **Schniedewind, Gerd, Dipl.-Ing.**
**30826 Garbsen (DE)**
• **Ludszuweit, Axel, Dipl.-Ing.**
**30853 Langenhagen (DE)**

(74) Vertreter: **Döring, Roger, Dipl.-Ing.**
**Alcatel Alsthom,**
**Intellectual Property Department,**
**Kabelkamp 20**
**30179 Hannover (DE)**

(54) **Schaltungsanordnung zur Einstellung einer Systemfrequenz**

(57) Es wird eine Schaltungsanordnung zur Einstellung einer Systemfrequenz angegeben, bei welcher ein eine Referenzfrequenz liefernder Frequenzgeber (XO) an einen ersten Phasenregelkreis (NCO) mit einem ersten Frequenzteiler, einem ersten Phasendetektor, einem ersten spannungsgesteuerten Oszillator und einem zwischen dem Ausgang des ersten Oszillators und dem Phasendetektor liegenden zweiten Frequenzteiler angeschlossen ist. Zur Einstellung unterschiedlicher Systemfrequenzen ist zwischen dem Frequenzgeber (XO) und dem ersten Phasenregelkreis (NCO) ein zweiter Phasenregelkreis mit einem zweiten Phasendetektor (PD2), einem zweiten spannungsgesteuerten Oszillator (VCO2) und einem zwischen dem Ausgang des zweiten Oszillators (VCO2) und dem zweiten Phasendetektor (PD2) liegenden dritten Frequenzteiler (K) eingeschaltet. Dabei sind der Frequenzgeber (XO) mit dem zweiten Phasendetektor (DP2) und der zweite Oszillator (VCO2) mit dem ersten Frequenzteiler (n) verbunden. An den Ausgang des ersten Oszillators (VCO1) ist ein vierter Frequenzteiler (K) mit seinem Eingang angeschlossen, an dessen Ausgang die Systemfrequenz ansteht.

EP 0 897 221 A1

**Beschreibung**

Die Erfindung bezieht sich auf eine Schaltungsanordnung zur Einstellung einer Systemfrequenz, bei welcher ein eine Referenzfrequenz liefernder Frequenzgeber an einen ersten Phasenregelkreis mit einem ersten Frequenzteiler, einem ersten Phasendetektor, einem ersten spannungsgesteuerten Oszillator und einem zwischen dem Ausgang des ersten Oszillators und dem Phasendetektor liegenden zweiten Frequenzteiler angeschlossen ist und bei welcher am Ausgang des ersten Oszillators eine Ausgangsfrequenz zur Verfügung steht (US-PS 5,256,980).

Eine solche Schaltungsanordnung wird beispielweise auf der Empfangsseite einer Übertragungsstrecke mit digitaler Signalübertragung verwendet. Dabei ist empfangsseitig eine einwandfreie Taktrückgewinnung erforderlich, damit die empfangenen Signale eindeutig weiterverarbeitet werden können. Bekannte Schaltungen zur Taktrückgewinnung werden aus Phasenregelkreisen gebildet, deren Ausgangsfrequenz (Systemfrequenz) das Arbeitsverhalten aller in der Empfangsschaltung vorhandenen elektrischen und elektronischen Komponenten beeinflußt. Ein solcher Phasenregelkreis kann beispielsweise mit einem numerisch gesteuerten Oszillator gemäß der US-PS 5,256,980 aufgebaut werden. Die Frequenz dieses Oszillators wird möglichst genau auf die Frequenz eines im Sender vorhandenen, dort als Taktgeber eingesetzten Quarzoszillators eingestellt. Der numerisch gesteuerte Oszillator muß für Anwendungen in der digitalen Signalübertragung typischerweise um mindestens +/- 100 ppm verstimmbar sein (Ziehbereich), um seine Frequenz und damit den Takt im Empfänger möglichen Schwankungen des Taktgebers im Sender und Verzerrungen des Empfangssignals sowie eigenen Fehlern anpassen zu können.

Die numerische Steuerung des Oszillators bzw. Phasenregelkreises gemäß der eingangs erwähnten US-PS 5,256,980 - im folgenden kurz mit "NCO" bezeichnet - dient der Feinabstimmung der Oszillatorfrequenz und der Phasenlage Diese Feinabstimmung führt bei dem numerisch gesteuerten Oszillator zu einem Eigenjitter, welcher einen festgelegten Grenzwert nicht überschreiten soll. Durch eine einmalige gleichzeitige Umschaltung der Teilerverhältnisse an den beiden Frequenzteilern des NCOs, welche jeweils nur während eines zeitlichen Taktintervalls gültig ist, werden die Phasen der beiden Frequenzen am Eingang des ersten Phasendetektors um unterschiedliche Zeitintervalle verschoben. Die Phase am Ausgang des NCOs wird um die Differenz dieser Zeitintervalle verschoben. Die Steuerung der NCO-Frequenz zum Zweck der Taktrückgewinnung wird in einem digitalen Phasenregelkreis mit Hilfe einer Schaltung durchgeführt, welche digital die erforderlichen Zeitintervalle zwischen den Umschaltperioden errechnet und damit die Häufigkeit der Umschaltungen festlegt. Durch geeignete Wahl von Parametern lassen sich der Eigenjitter und der Ziehbereich des NCOs in günstiger Weise beeinflussen. Der Wahl dieser Parameter sind allerdings aufgrund der Realisierbarkeit Grenzen gesetzt. Auch Eigenjitter und Ziehbereich des NCOs müssen innerhalb vorgegebener Grenzen liegen. Daher müssen Referenzfrequenz und Ausgangsfrequenz des NCOs bestimmte Werte einhalten. Der Einsatz dieser Schaltungsanordnung ist somit - bezogen auf die gegebenen Übertragungsraten bzw. Systemfrequenzen - auf einen relativ engen Frequenzbereich begrenzt.

Der Erfindung liegt die Aufgabe zugrunde, die eingangs geschilderte Schaltungsanordnung so weiterzubilden, daß der Eigenjitter und der Ziehbereich derselben über einen weiten Systemfrequenzbereich auf akzeptable Werte eingestellt werden können.

Diese Aufgabe wird gemäß der Erfindung dadurch gelöst,

- daß zwischen dem Frequenzgeber und dem ersten Phasenregelkreis ein zweiter Phasenregelkreis mit einem zweiten Phasendetektor, einem zweiten spannungsgesteuerten Oszillator und einem zwischen dem Ausgang des zweiten Oszillators und dem zweiten Phasendetektor liegenden dritten Frequenzteiler eingeschaltet ist, wobei der Frequenzgeber mit dem zweiten Phasendetektor und der zweite Oszillator mit dem ersten Frequenzteiler verbunden sind und

- daß an den Ausgang des ersten Oszillators ein vierter Frequenzteiler mit seinem Eingang angeschlossen ist, an dessen Ausgang die Systemfrequenz ansteht.

Bei dieser Schaltungsanordnung wird ein zweiter Phasenregelkreis eingesetzt, durch welchen aus einer fest eingestellten Referenzfrequenz eine variable Eingangsfrequenz für den NCO erzeugt wird. Durch den am Ausgang des NCOs angeschlossenen vierten Frequenzteiler wird dann die gewünschte Systemfrequenz eingestellt. und zwar für alle gebräuchlichen Ubertragungsraten. Dabei wird durch richtige Einstellung des vierten Frequenzteilers sichergestellt, daß der Oszillator stets etwa mit seiner mittleren Schwingfrequenz arbeitet.

Der Bereich, innerhalb dessen die beiden Frequenzteiler des NCOs umgeschaltet werden, kann konstant gehalten werden. Die Ausgangsfrequenz der spannungsgesteuerten Oszillatoren kann außerdem auf einen relativ engen Bereich hoher Frequenzen begrenzt bleiben. Damit sind die Forderungen nach einem begrenzten Ziehbereich der Oszillatoren einerseits und nach einem geringen Eigenjitter andererseits auf einfache Weise erfüllt.

Für diese Schaltungsanordnung ergeben sich somit folgende Vorteile:
Die benötigte Systemfrequenz kann auf einfache Weise in einem beliebig großen Bereich eingestellt werden, wobei lediglich der dritte und der vierte Frequenzteiler verändert werden müssen. Das kann innerhalb einer fest vorgegebenen integrierten Halbleiterschaltung realisiert werden. Aufgrund der zusätzlichen Freiheitsgrade durch die variable Eingangsfrequenz für den NCO und den vierten Frequenzteiler am Ausgang des NCOs können für alle Systemfrequenzen der Eigenjitter ausreichend gering und der relative Ziehbereich ausreichend groß gehalten werden. Die Schwingfrequenz der beiden Oszillatoren muß nur geringfügig verändert werden.

Ausführungsbeispiele des Erfindungsgegenstandes sind in den Zeichnungen dargestellt.

Es zeigen jeweils in Blockschaltbildern:

Fig. 1 einen NCO nach dem Stand der Technik.

Fig. 2 eine Schaltungsanordnung nach der Erfindung.

Fig. 3 eine gegenüber Fig. 2 ergänzte Schaltungsanordnung.

In der folgenden Beschreibung wird der Einfachheit halber statt des Wortes »Frequenzteiler" das kürzere Wort" "Teiler« verwendet.

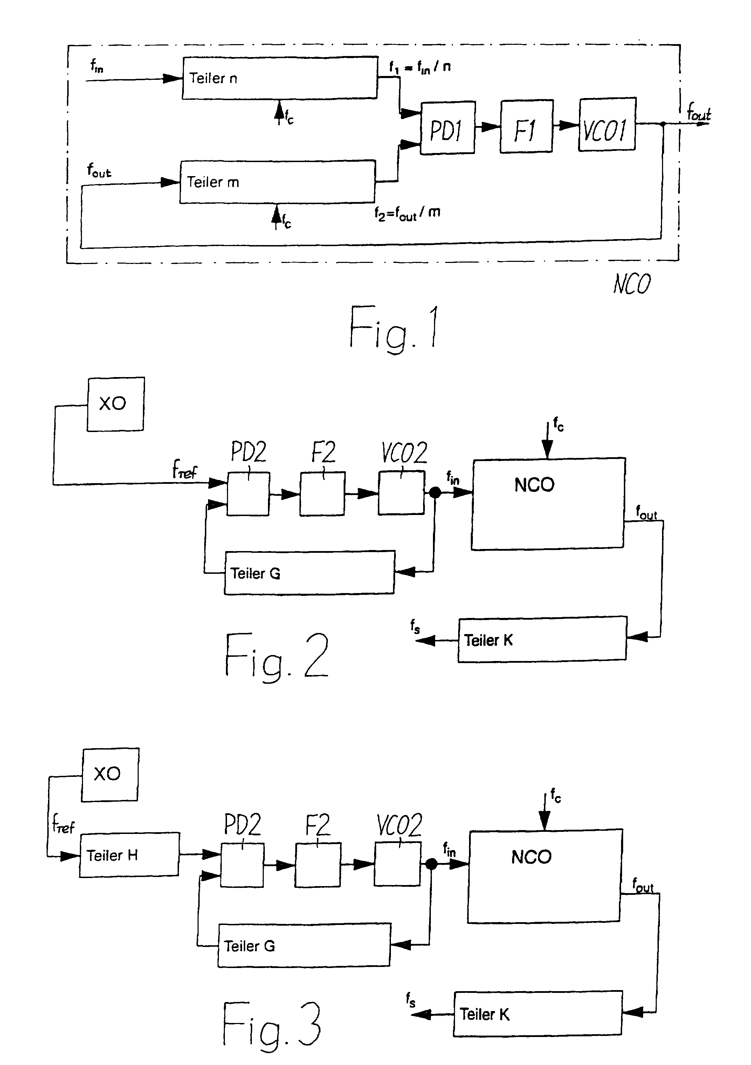

In Fig. 1 ist ein bekannter, auf numerischem Wege fein abstimmbarer Phasenregelkreis bzw. Oszillator dargestellt, der im folgenden weiter mit ,,NCO" bezeichnet wird. Er ist in Fig. 1 strichpunktiert umrandet. Der NCO besteht aus einem ersten Teiler n, einem ersten Phasendetektor PD1, einem ersten Schleifenfilter F1, einem ersten spannungsgesteuerten Oszillator VCO1 und einem zweiten Teiler m als Rückkopplungsteiler. Dem ersten Teiler n wird eine extern erzeugte, feste Referenzfrequenz als Eingangsfrequenz $f_{in}$ aufgegeben. Er ist an den PD1 angeschlossen und liefert die Frequenz $f_1 = f_{in}/n$. Das F1 bereitet das Ausgangssignal des PD1 für den VCO1 auf und beeinflußt allgemein das dynamische Verhalten des NCOs. Dem zweiten Teiler m wird die Ausgangsfrequenz $f_{out}$ des NCOs aufgegeben. Er ist in Rückkopplungsschaltung ebenfalls mit dem PD1 verbunden und liefert die Frequenz $f_2 = f_{out}/m$.

Der NCO nach Fig. 1 ist ein Phasenregelkreis. Seine Ausgangsfrequenz $f_{out}$ ist von der Eingangsfrequenz $f_{in}$ abgeleitet. Im eingerasteten Zustand des NCOs gilt:

$$f_1 = f_2.$$

Durch eine einmalige, gleichzeitige Umschaltung der Teilerverhältnisse an den beiden Teilern n und m um einen Betrag $d_n$ bzw. $d_m$, welche nur während eines zeitlichen Taktintervalls t gültig ist, werden die Phasen der Frequenzen $f_1$ und $f_2$ am Eingang des PD1 derart verschoben, daß die Phase der Ausgangsfrequenz $f_{out}$ des NCOs um

$$\Delta T = ((n \pm d_n) / f_{in}) - ((m \pm d_m) / f_{out})$$

verschoben wird.

Wird diese Umschaltung mit einer Frequenz $f_c$ wiederholt, dann ergibt sich im eingerasteten Zustand für die Schwingfrequenz $f_{out}$ des NCO:

$$f_{out} = f_{in} * (m/n) * 1/(1 + f_c * \Delta T).$$

Die Amplitude des Eigenjitters des NCOs wird wesentlich durch die Amplitude des Zeitintervalls $\in T$ bestimmt. Die Wiederholfrequenz $f_c$ beschreibt die Grundfrequenz des Eigenjitters.

Schaltungsanordnungen zur Erzeugung einer in weiten Grenzen veränderbaren Systemfrequenz gehen aus den Fig. 2 und 3 hervor:

Zur Erzeugung einer variablen Eingangsfrequenz für den NCO ist demselben ein zweiter Phasenregelkreis vorangeschaltet, dem von einem Frequenzgeber XO eine fest eingestellte Referenzfrequenz $f_{ref}$ zugeführt wird. Die Referenzfrequenz $f_{ref}$ wird einem zweiten Phasendetektor PD2 entweder direkt (Fig. 2) oder über einen fünften Teiler H (Fig. 3) aufgegeben. An den PD2 sind ein zweites Schleifenfilter F2 und ein zweiter spannungsgesteuerter Oszillator VCO2 angeschlossen. Die Ausgangsfrequenz $f_{in}$ des VCO2 wird über einen dritten Teiler G rückgekoppelt und dem PD2 aufgegeben. Die Funktion des F2 ist die gleiche wie die des F1 gemäß Fig. 1.

Wenn die Referenzfrequenz $f_{ref}$ eine geeignete Größe hat, kann sie entsprechend Fig 2 dem PD2 direkt aufgegeben werden. Da die auf dem Markt befindlichen Frequenznormale überwiegend aber höhere Frequenzen liefern, muß die feste Referenzfrequenz $f_{ref}$ heruntergeteilt werden. In der weiteren Beschreibung wird daher die Ausführungsform der Schaltungsanordnung nach Fig. 3 berücksichtigt. Die Ausgangsfrequenz $f_{in}$ des VCO2 wird dem NCO als variable Eingangsfrequenz aufgegeben. Dessen Ausgangsfrequenz $f_{out}$ wird einem vierten Teiler K zugeführt, an dessen Ausgang die Systemfrequenz $f_s$ zur Verfügung steht.

Die variable Ausgangsfrequenz $f_{in}$ des VCO2 ergibt sich unter Berücksichtigung der Teilerverhältnisse der Teiler G und H zu:

$$f_{in} = f_{ref} * G/H.$$

Die Ausgangsfrequenz $f_{out}$ des NCO wird durch den Teiler K auf die gewünschte Systemfrequenz $f_s$ heruntergeteilt:

$$f_s = f_{ref} * (G*m)/(H*K*n) + f_c * (d_m - (m/n)*d_n)/K.$$

Mit der Schaltungsanordnung nach Fig. 3 werden folgende Anforderungen gleichzeitig erfüllt:

- Es sind viele Systemfrequenzen $f_s = c*f_{dist}$ mit c = 1, 2, 3, ...$c_{max}$ einstellbar, welche alle Vielfache einer Frequenz $f_{dist}$ sein können.

- Der durch die Feinabstimmung entstehende Eigenjitter der eingesetzten Oszillatoren überschreitet nicht einen festgelegten Grenzwert.
- Die Systemfrequenzen lassen sich innerhalb eines ausreichend großen Ziehbereiches einstellen.
- Es wird nur eine feste, quarzstabile Referenzfrequenz $f_{ref}$ benötigt.

Die Schaltungsanordnung mit den einstellbaren Teilern H, G und K bringt also zusätzliche Freiheitsgrade. Durch gezielte Auswahl der Teilerverhältnisse G und K können unter Einhaltung der aufgeführten Bedingungen für Eigenjitter und Ziehbereich nahezu alle gewünschten Systemfrequenzen $f_s$ eingestellt werden. Für die Einstellung der Teiler K und G gilt beispielsweise folgendes:

Der Teiler K soll so eingestellt werden, daß sich eine möglichst geringe Abweichung von der mittleren Schwingfrequenz $f_{out}$ des VCO1 im numerisch gesteuerten Oszillator NCO ergibt. Da die einzustellende Systemfrequenz $f_s$ bekannt ist, kann diese Bedingung durch den Teiler K auf einfache Weise eingehalten werden. Die dem NCO aufzugebende Eingangsfrequenz $f_{in}$ hängt ebenfalls von der einzustellenden Systemfrequenz $f_s$ ab. Sie wird durch den Teiler G auf den erforderlichen Wert eingestellt.

Im folgenden werden zwei Beispiele für die Einstellung der Teiler K und G gegeben: Es soll eine Systemfrequenz $f_s = 37{,}12$ MHz eingestellt werden. Die mittlere Schwingfrequenz des VCO1 beträgt 80 MHz. Der Teiler K erhält dann die Einstellung K = 2. Mit $f_{out} = K * f_s$ ergibt das für den VCO1 die Schwingfrequenz

$$f_{out} = 74{,}24 \text{ MHz}$$

Analog dazu ergibt sich für eine Systemfrequenz $f_s = 2{,}304$ MHz das Teilerverhältnis K = 35. Die Schwingfrequenz des VCO1 ist dann:

$$f_{out} = 80{,}64 \text{ MHz}$$

Die Grundeinstellung der Teiler m und n des NCOs wird so gewählt, daß die Anforderungen für den Eigenjitter und den Ziehbereich im Falle der Feineinstellung für den VCO1 erfüllt werden. Der Eigenjitter und der Ziehbereich sind insbesondere von den Teilervariablen m und n sowie von der Ausgangsfrequenz $f_{out}$ abhängig. Da die Schwingfrequenz des VCO1 durch den Teiler K immer in der Nähe seiner Mittenfrequenz gehalten wird, kann diese Grundeinstellung für alle gewünschten Systemfrequenzen beibehalten werden, ohne daß sich der Eigenjitter bzw. der Ziehbereich wesentlich verändern.

Der NCO benötigt in diesem Sinne eine Eingangsfrequenz $f_{in}$, für welche gilt:

$$f_{in} = f_{out} * n/m.$$

Durch die Festlegung von n und m ist der Frequenzbereich für $f_{in}$, welche durch den VCO2 des vorgeschalteten zweiten Phasenregelkreises erzeugt wird, ebenfalls auf einen kleinen Bereich beschränkt.

Soll die Systemfrequenz $f_s$ in Schritten von z. B. 256 kHz umschaltbar sein, dann gilt dies in gleicher Weise für die Ausgangsfrequenz $f_{out} = K * f_s$. Wenn die Teiler n und m beispielsweise mit n = 25 und m = 24 eingestellt werden, muß die variable Eingangsfrequenz $f_{in}$ in Schritten von

$$256 \text{ kHz} * n/m = 266.6 \text{ kHz}$$

einstellbar sein. Sie hat für die beiden erwähnten Systemfrequenzen $f_s = 37{,}12$ MHz und $f_s = 2{,}304$ MHz die Werte $f_{in} = 77{,}3$ MHz und $f_{in} = 84{,}0$ MHz.

Für den Teiler G gilt:

$$G = f_{in} / 266{,}6 \text{ kHz}.$$

Die 266,6 kHz liegen am PD2 an. Für die beiden genannten Systemfrequenzen wird der Teiler G dann auf die werte G = 315 bzw. G = 290 eingestellt.

Der Teiler H kann für beide Beispiele eine feste Einstellung behalten. Er dient lediglich zur Anpassung an die Referenzfrequenz $f_{ref}$. Für H = 30 ergibt sich z. B. eine Referenzfrequenz von $f_{ref} = 8{,}0$ MHz.

**Patentansprüche**

1. Schaltungsanordnung zur Einstellung einer Systemfrequenz, bei welcher ein eine Referenzfrequenz liefernder Frequenzgeber an einen ersten Phasenregelkreis mit einem ersten Frequenzteiler, einem ersten Phasendetektor, einem ersten spannungsgesteuerten Oszillator und einem zwischen dem Ausgang des ersten Oszillators und dem Phasendetektor liegenden zweiten Frequenzteiler angeschlossen ist und bei welcher am Ausgang des ersten Oszillators eine Ausgangsfrequenz zur Verfügung steht, dadurch gekennzeichnet,

- daß zwischen dem Frequenzgeber und dem ersten Phasenregelkreis ein zweiter Phasenregelkreis mit einem zweiten Phasendetektor (PD2), einem zweiten spannungsgesteuerten Oszillator (VCO2) und einem zwischen dem Ausgang des zweiten Oszillators (VCO2) und dem zweiten Phasendetektor (PD2) liegenden dritten Frequenzteiler (K) eingeschaltet ist, wobei der Frequenzgeber mit dem zweiten Phasendetektor (DP2) und der zweite Oszillator (VCO2) mit dem ersten Frequenzteiler (n).verbunden sind und

- daß an den Ausgang des ersten Oszillators (VCO1) ein vierter Frequenzteiler (K) mit seinem Eingang angeschlossen ist, an dessen Ausgang die Systemfrequenz ansteht.

2.  Schaltungsanordnung nach Anspruch 1, <u>dadurch gekennzeichnet,</u> daß zwischen Frequenzgeber und zweitem Phasenregelkreis ein fünfter Frequenzteiler (H) eingeschaltet ist.

Fig.1

Fig.2

Fig.3

Europäisches
Patentamt

**EUROPÄISCHER RECHERCHENBERICHT**

Nummer der Anmeldung

EP 98 40 1803

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | W.A. EVANS U.A.: "A microprocessor-controlled phase-locked signal source" RADIO AND ELECTRONIC ENGINEER., Bd. 48, Nr. 12, Dezember 1978, Seiten 593-602, XP002082177 LONDON   GB * Seite 593, Absatz SUMMARY * * Seite 594, Spalte 1, Zeile 2 - Zeile 47 * * Seite 595, Spalte 2, Zeile 25 - Seite 597, Spalte 1, Zeile 15; Abbildung 3 * --- | 1,2 | H03L7/23 |
| A,D | US 5 256 980 A (ITRI BENEDICT A) 26. Oktober 1993 * Spalte 3, Zeile 15 - Spalte 8, Zeile 36; Abbildungen 2A-5 * ----- | 1,2 | |
| | | | **RECHERCHIERTE SACHGEBIETE (Int.Cl.6)** H03L |

Der vorliegende Recherchenbericht wurde für alle Patentansprüche erstellt

| Recherchenort | Abschlußdatum der Recherche | Prüfer |
|---|---|---|
| DEN HAAG | 27. Oktober 1998 | Balbinot, H |

EPO FORM 1503 03.82 (P04C03)